# EUROPEAN PATENT APPLICATION

(11) **EP 2 799 998 A1**
(43) Date of publication of application: **05.11.2014**
(21) Application number: 12866004.0
(22) Date of filing: 19.10.2012
(51) Int. Cl.: G06F 12/16, G06F 11/00, G11C 13/00

(54) **STORAGE CONTROL DEVICE, STORAGE DEVICE, INFORMATION PROCESSING SYSTEM, AND PROCESSING METHODS IN SAME**

(30) Priority: 16.01.2012 JP 2012005780
(71) Applicant: Sony Corporation, Tokyo 108-0075 (JP)
(72) Inventor: ADACHI, Naohiro, Tokyo 108-0075 (JP); OKUBO, Hideaki, Tokyo 108-0075 (JP); YAMAMOTO, Makiko, Tokyo 108-0075 (JP); TSUTSUI, Keiichi, Tokyo 108-0075 (JP); NAKANISHI, Kenichi, Tokyo 108-0075 (JP); FUJINAMI, Yasushi, Tokyo 108-0075 (JP)
(74) Representative: Berryman, Robert Jan
(86) International application number: PCT/JP2012/077081
(87) International publication number: WO 2013/108456

(57) **Abstract**

Provided is a storage control device including a history information holding unit configured to hold history information in a predetermined data area of a memory cell holding either a first value or a second value for each bit, the history information indicating which mode of a first mode or a second mode is employed upon a previous write operation, the first mode setting all bits to the first value and then setting any bit to the second value, the second mode setting all bits to the second value and then setting any bit to the first value, and a bitwise operation unit configured to perform a write operation in the second mode if the history information indicates the first mode and to perform a write operation in the first mode if the history information indicates the second mode.

## Description

### Technical Field

The present technology relates to a storage control device. Particularly, this technology relates to a storage control device, a storage device, an information processing system, and a processing method thereof for non-volatile memories, and a program that instructs a computer to execute the method.

### Background Art

In an information processing system, a DRAM (Dynamic Random Access Memory), or the like is used as a work memory. Such a DRAM is generally a volatile memory, and thus, content stored in the memory is lost when power supply is interrupted. On the other hand, non-volatile memories (NVM: Non-Volatile Memories) have been used in recent years. Such non-volatile memories are broadly divided into flash memories for data access in a large data amount and non-volatile random access memory (NVRAM: Non-Volatile RAM) that can randomly access data in a small data amount at a high speed. Here, as a typical example of flash memories, a NAND-type flash memory can be exemplified. On the other hand, as examples of non-volatile random access memories, a ReRAM (Resistance RAM), a PCRAM (Phase-Change RAM), a MRAM (Magnetoresistive RAM), and the like can be exemplified.

The ReRAM is non-volatile memory that uses a variable resistance element, and it is possible to perform the direct rewriting only on a necessary page without the need to perform erasing in units of blocks prior to writing of data. In this regard, it is different from NAND flash memory and other memory that stores a threshold value of the electrification storage amount of a floating gate as data. In a variable resistance element, information of one bit in two states which are a high resistive state (HRS: High Resistive State) and a low resistive state (LRS: Low Resistive State) can be recorded. When a voltage of the same polarity is continuously applied to such a variable resistance element many times, there is a problem of disturbance in the resistivity distribution that resistance value of the variable resistance treatment is changed. For example, as the same polarity is continuously applied with increasing number of times, HRS will be changed to LRS, and LRS will be changed to HRS. If the resistance value is changed in this way, when the voltage of opposite polarity is applied in the next time, there is a risk that recording is not performed appropriately at the same voltage as the normal state or a voltage with a large absolute value is necessary to perform appropriate recording. Thus, in related art, there has been proposed a writing method of rewriting and erasing only a necessary bit in a selective manner by reading out data written previously at the time of write process and comparing it with write data (for example, refer to Patent Literature 1).

### Citation List

### Patent Literature

Patent Literature 1: JP 2007-525785T

### Summary of Invention

### Technical Problem

In the related art described above, when the data written previously and the write data are the same data, a write pulse is not generated, and thus identical data is not to be written continuously. However, when such a control is performed, if a bit is rewritten more frequently or all of certain bits are not rewritten due to the repetition of a writing cycle, then the frequency of use of the memory cells will be different even between memory cells in the same page. In other words, the repetitive rewriting results in variations in the number of rewritable times (Endurance) of a memory cell in the same page and further variations in the time until data is lost (Retention). For a bit having high frequency of use and a bit having low frequency of use, variations in characteristics of a memory cell occur and the resistance distribution will be disturbed. If variations in the number of rewritable times or the time to data loss occur for each bit in a page, in practical use, it becomes difficult to predict the lifetime as a memory of the relevant page by counting rewriting and erasure cycles. In addition, if an attempt is made to change for dynamically changing the threshold value of readout or its verification, it is preferable to reduce variations in characteristics of a memory cell in the relevant page.

The present technology is made in view of such circumstances, and an object thereof is to eliminate variations in data retention characteristics of non-volatile memory.

### Solution to Problem

The present technology has been made in order to solve the above-mentioned issues. According to the first aspect of the present technology, there is provided a storage control device including a history information holding unit configured to hold history information in a predetermined data area of a memory cell holding either a first value or a second value for each bit, the history information indicating which mode of a first mode or a second mode is employed upon a previous write operation, the first mode setting all bits to the first value and then setting any bit to the second value, the second mode setting all bits to the second value and then setting any bit to the first value, and a bitwise operation unit configured to perform a write operation in the second mode if the history information indicates the first mode and to perform a write operation in the first mode if the history information indicates the second mode. Accordingly, in the storage control device, there is an effect that a mode in which all bits are set to the first value and a mode in which all bits are set to the second value are alternatively repeated each time when a write operation is performed on a predetermined data area of a memory cell.

According to the first aspect of the present technology, the storage control device may further include a pre-read processing unit configured to read pre-read data from a data area to be written prior to a write operation. The bitwise operation unit rewrites only a bit in which the pre-read data indicates the second value to the first value to set all bits to the first value when the write operation in the first mode is performed, and rewrites only a bit in which the pre-read data indicates the first value to the second value to set all bits to the second value when the write operation in the second mode is performed. Accordingly, there is an effect of suppressing over-erasure or over-programming when all bits are set to the first value or the second value.

According to the first aspect of the present technology, the bitwise operation unit may rewrite all bits in a data area to be written to the first value to set all bits to the first value when the write operation in the first mode is performed, and rewrite all bits in a data area to be written to the second value to set all bits to the second value when the write operation in the second mode is performed. Accordingly, there is an effect of performing the batch erasure or batch programming when all bits are set to the first value or the second value. In addition, this makes it possible to suppress writing of the same polarity up to a maximum of twice. That is, the over-erasure or over-programming to a variable resistance element is suppressed up to a maximum of one time, respectively.

According to the first aspect of the present technology, the storage control device may further include a pre-read processing unit configured to read pre-read data from a data area to be written prior to a write operation. The bitwise operation unit may rewrite all bits in a data area to be written to the first value to set all bits to the first value when the write operation in the first mode is performed, and rewrite only a bit in which the pre-read data indicates the first value to the second value to set all bits to the second value when the write operation in the second mode is performed. Accordingly, there is an effect that the over-programming is suppressed when all bits are set to the first value, and the batch erasure is performed when all bits are set to the second value.

According to the second aspect of the present technology, there is provided a storage device including a memory cell configured to hold either a first value or a second value for each bit, a history information holding unit configured to hold history information in a predetermined data area of the memory cell, the history information indicating which mode of a first mode or a second mode is employed upon a previous write operation, the first mode setting all bits to the first value and then setting any bit to the second value, the second mode setting all bits to the second value and then setting any bit to the first value, and a bitwise operation unit configured to perform a write operation in the second mode if the history information indicates the first mode and to perform a write operation in the first mode if the history information indicates the second mode. Accordingly, there is an effect that a mode in which all bits are set to the first value and a mode in which all bits are set to the second value are alternatively repeated each time when a write operation is performed on a predetermined data area of a memory cell.

According to the second aspect of the present technology, there is provided the memory cell may be a variable resistance element.

According to the second aspect of the present technology, there is provided an information processing system including a memory cell configured to hold either a first value or a second value for each bit, a history information holding unit configured to hold history information in a predetermined data area of the memory cell, the history information indicating which mode of a first mode or a second mode is employed upon a previous write operation, the first mode setting all bits to the first value and then setting any bit to the second value, the second mode setting all bits to the second value and then setting any bit to the first value, a bitwise operation unit configured to perform a write operation in the second mode if the history information indicates the first mode and to perform a write operation in the first mode if the history information indicates the second mode, and a host computer configured to issue a read command or a write command to the memory array. Accordingly, in the storage device, there is an effect that a mode in which all bits are set to the first value and a mode in which all bits are set to the second value are alternatively repeated each time when a write operation from a host computer is performed on a predetermined data area of a memory cell.

According to the second aspect of the present technology, there is provided a storage controlling method including performing a history information obtaining process of obtaining history information for a predetermined data area of a memory cell holding either a first value or a second value for each bit, the history information indicating which mode of a first mode or a second mode is employed upon a previous write operation, the first mode setting all bits to the first value and then setting any bit to the second value, the second mode setting all bits to the second value and then setting any bit to the first value, and performing a bitwise operation process of performing a write operation in the second mode if the history information indicates the first mode and performing a write operation in the first mode if the history information indicates the second mode. Accordingly, there is an effect that a mode in which all bits are set to the first value and a mode in which all bits are set to the second value are alternatively repeated each time when a write operation is performed on a predetermined data area of a memory cell.

### Advantageous Effects of Invention

According to the present technology, there is an excellent effect of allowing variations in data retention characteristics of non-volatile memory to be eliminated.

### Brief Description of Drawings

[FIG. 1] FIG. 1 is a diagram illustrating an exemplary configuration of an information processing system according to an embodiment of the present technology.
[FIG. 2] FIG. 2 is a diagram illustrating an exemplary configuration of a non-volatile random access memory (NVRAM) 301 according to a first embodiment of the present technology.
[FIG. 3] FIG. 3 is a diagram illustrating an exemplary functional configuration according to an embodiment of the present technology.
[FIG. 4] FIG. 4 is a diagram illustrating a specific example of performing writing on a variable resistance element according to the first embodiment of the present technology.
[FIG. 5] FIG. 5 is a flow diagram illustrating an exemplary procedure of a write process of the information processing system according to the first embodiment of the present technology.
[FIG. 6] FIG. 6 is a flow diagram illustrating an exemplary procedure of a write process in an entire erasure mode according to the first embodiment of the present technology.
[FIG. 7] FIG. 7 is a flow diagram illustrating an exemplary procedure of a write process in an entire programming mode according to the first embodiment of the present technology.
[FIG. 8] FIG. 8 is a diagram illustrating an exemplary configuration of a NVRAM 301 according to a second embodiment of the present technology.
[FIG. 9] FIG. 9 is a diagram illustrating an exemplary configuration of a history information table according to the second embodiment of the present technology.
[FIG. 10] FIG. 10 is a diagram illustrating a specific example of performing writing on a variable resistance element according to the second embodiment of the present technology.
[FIG. 11] FIG. 11 is a flow diagram illustrating an exemplary procedure of a write process of an information processing system according to the second embodiment of the present technology.
[FIG. 12] FIG. 12 is a flow diagram illustrating an exemplary procedure of a write process in an entire erasure mode according to the second embodiment of the present technology.
[FIG. 13] FIG. 13 is a flow diagram illustrating an exemplary procedure of a write process in an entire programming mode according to the second embodiment of the present technology.
[FIG. 14] FIG. 14 is a diagram illustrating a specific example of performing writing on a variable resistance element according to a third embodiment of the present technology.
[FIG. 15] FIG. 15 is a flow diagram illustrating an exemplary procedure of a write process of an information processing system according to the third embodiment of the present technology.
[FIG. 16] FIG. 16 is a flow diagram illustrating an exemplary procedure of a write process in an entire programming mode according to the third embodiment of the present technology.

### Description of Embodiments

In the following, modes for implementing the present technology (hereinafter, referred to as embodiment) will be described. The description will be given in the following order.
1. First Embodiment (an example of performing pre-reading to allow all bits to be set to the same value)
2. Second Embodiment (an example in which pre-reading is not performed when all bits are set to the same value)
3. Third Embodiment (an example of performing pre-reading every other time when all bits are set to the same value)

### <1. First Embodiment>

### [Configuration of Information Processing System]

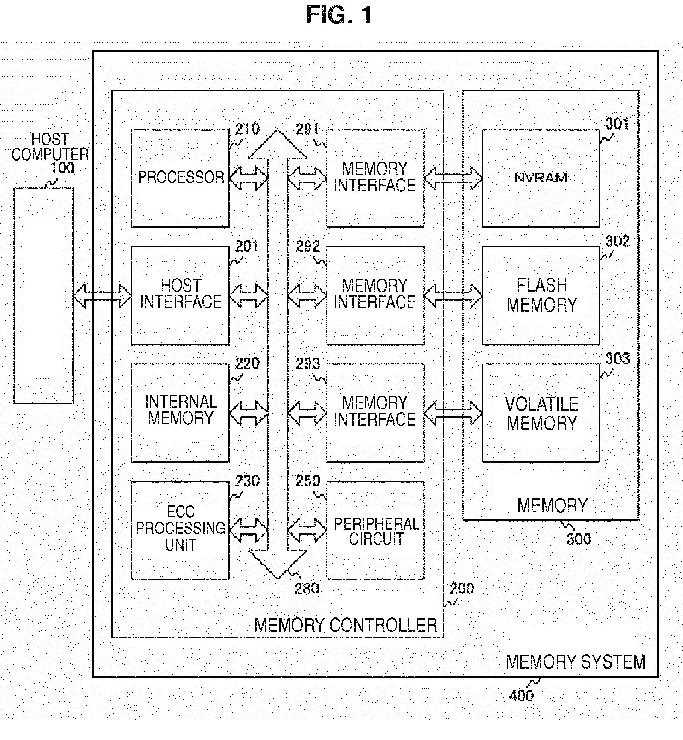

FIG. 1 is a diagram illustrating an exemplary configuration of an information processing system according to an embodiment of the present technology. The information processing system includes a host computer 100, a memory 300, and a memory controller 200. The memory controller 200 and the memory 300 constitute a memory system 400. The host computer 100 issues a command to request a data read or write from or in the memory system 400.

The memory 300 includes non-volatile memory in addition to a typical volatile memory 303. The non-volatile memory is classified roughly into a flash memory 302 that allows data access to be performed for large amount of data and a non-volatile random access memory (NVRAM) 301 that allows random access to be performed for small amount of data at a high speed. Here, as a typical example of the flash memory 302, NAND-type flash memory can be exemplified. On the other hand, as an example of the NVRAM 301, ReRAM, PCRAM, MRAM or the like can be exemplified, but it is assumed that in this embodiment the ReRAM especially using a variable resistance element is used. The volatile memory 303 is used as a working area, and is also used to store data for management. Furthermore, the volatile memory 303 can also be used as a cache. The volatile memory 303 can be implemented by DRAM, SRAM, and other memory. Data that is stored in the volatile memory 303 is held in the NVRAM 301 or the flash memory 302 as necessary in preparation for power cut-off, so that it may be re-used when the power is turned on later.

The memory controller 200 includes a processor 210, an internal memory 220, an ECC processing unit 230, a peripheral circuit 250, a host interface 201, and memory interfaces 291 to 293. They are connected to each other via a bus 280.

The processor 210 is a processing device that interprets and executes a control command from the host computer 100. This processor 210 executes a program by regarding a storage area in the internal memory 220 as a program storage area and work area thereof.

The internal memory 220 is a memory that includes internal ROM and RAM which are not shown. A program may be stored in the internal ROM or may be transferred to the internal RAM from the NVRAM 301 or the flash memory 302 at startup. The internal RAM is used in various applications, for example, as a work area or an area for temporarily storing data for management or the like.

The ECC processing unit 230 generates an error correcting code (ECC: Error Correcting Code) which is added to each of data in association with each other and performs error correction using the ECC. The ECC processing unit 230 may be implemented in hardware or may be implemented in software by allowing the processor 210 to execute a program.

The peripheral circuit 250 is a peripheral circuit of the processor 210, and includes, for example, a built-in timer, general-purpose input/output (GPIO: General Purpose Input/Output), or the like.

The host interface 201 is an interface for performing interaction with the host computer 100. The memory system 400 operates as a memory system which is connected through the host interface, receives a control command for controlling the memory 300 from the host computer 100, and is controlled by the control command. As the host interface 201, for example, SATA, PCI Express, eMMC, USB or the like can be used.

The memory interface 291 is an interface that performs interaction with the NVRAM 301. The memory interface 292 is an interface that performs interaction with the flash memory 302. The memory interface 293 is an interface that performs interaction with the volatile memory 303.

The memory system 400 writes data in the memory 300 by a write command and reads data from the memory 300 by a read command. The write and read commands allows a head logical address where a target data exists and data size to be specified as a parameter. When the memory system 400 receives data of a write command, ECC is added to the data to be written to the non-volatile memory (NVRAM 301 or flash memory 302).

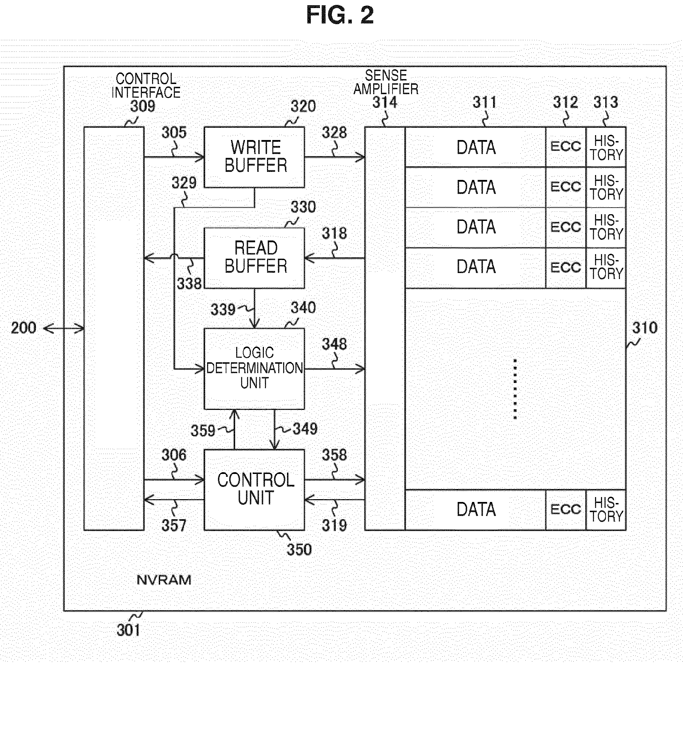

FIG. 2 is a diagram illustrating an exemplary configuration of the non-volatile random access memory (NVRAM) 301 according to the first embodiment of the present technology. The NVRAM 301 includes a memory array 310, a sense amplifier 314, a write buffer 320, a read buffer 330, a logic determination unit 340, a control unit 350, and a control interface 309.

The control interface 309 is an interface that takes charge of the connection with the memory controller 200. The control interface 309 is connected with the write buffer 320, the read buffer 330, the logic determination unit 340, and the control unit 350.

The memory array 310 is an array in which memory cells, which retain a predetermined state for each bit, are arranged in a lattice pattern. The memory cell of the memory array 310 is resistive random access memory composed of a variable resistance element. The memory array 310 is composed of a plurality of pages. The page stores therein ECC 312 and history information 313, in addition to data 311. The ECC 312 is an error-correcting code used to perform the error detection and correction on the data 311. The history information 313 indicates that any one mode was used in the previous write operation. If there are two types of modes for the write operation, the history information 313 is sufficient to have only one bit, however it may be possible to determine a mode, for example by the majority decision, using a plurality of bits to improve reliability. In the memory array 310, readout or write-in is performed by way of the sense amplifier 314.

The sense amplifier 314 is an amplifier circuit used to amplify a voltage from the memory array 310. The sense amplifier 313 is connected with the write buffer 320, the read buffer 330, the logic determination unit 340, and the control unit 350.

The write buffer 320 is a buffer for temporarily holding data to be written in the memory array 310. The write buffer 320 holds write data provided from the control interface 309 via a signal line 305 and outputs it to the sense amplifier 313 via a signal line 328. The write data held in the write buffer 320 is new data indicated as a target to be written from the host computer 100 and a new error correcting code generated by the ECC processing unit 230. In the following, these new data and error correcting code are referred to as write data.

The read buffer 330 is a buffer for temporarily holding the data 311, the ECC 312, and the history information 313 which are read from the memory array 310. The read buffer 330 holds the pre-read data (data 311, ECC 312, and history information 313) which is read prior to writing at the time of writing. The read buffer 330 holds read data provided from the sense amplifier 314 via a signal line 318, and outputs it to the control interface 309 via a signal line 338.

The logic determination unit 340 performs logic determination based on the data (data 311, ECC 312, and history information 313) held in the write buffer 320 and the read buffer 330 to generate mask data. The mask data generated by the logic determination unit 340 is supplied to the memory array 310 via a signal line 348. In addition, the history information 313 is supplied to the control unit 350 via a signal line 349.

The control unit 350 is a controller for controlling each block in the NVRAM 301. The control unit 350 is implemented, for example, by a sequencer. The control unit 350 receives a read or write instruction or the like from the control interface 309 via a signal line 306 and transmits a response to the control interface 309 via a signal line 357. In addition, the control unit 350 transmits a control signal to the sense amplifier 314 via a signal line 358 and receives a response from the sense amplifier 314 via a signal line 319. Additionally, the control unit 350 transmits a control signal to the logic determination unit 340 via a signal line 359.

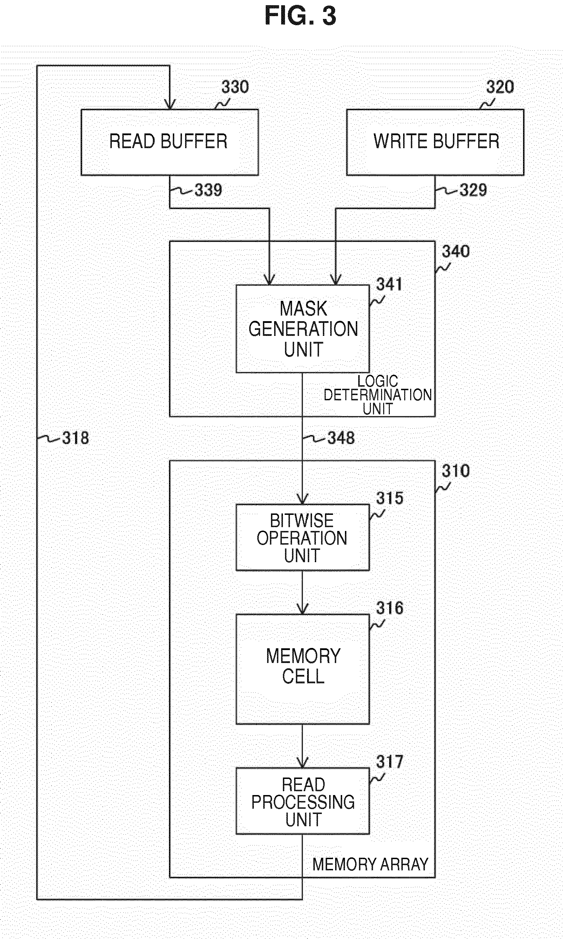

FIG. 3 is a diagram illustrating an exemplary functional configuration according to an embodiment of the present technology. In this example, it is assumed that the logic determination unit 340 has a function of a mask generation unit 341, and the memory array 310 has functions of a bitwise operation unit 315, a memory cell 316, and a read processing unit 317.

The mask generation unit 341 generates an erasing mask or programming mask composed of corresponding bits. The erasing mask indicates that H level is erased to L level for a bit in which the pre-read data is H level and the write data is L level, and the other bits are masked. The programming mask indicates that L level is programmed to H level for a bit in which the pre-read data is L level and the write data is H level, and the other bits are masked. In the embodiment of the present technology, a mask is generated and the bitwise operation is performed without a comparison between the pre-read data and the write data. As described later, in the first embodiment, there is generated mask data for allowing the bits to be all set to L or H once from only the pre-read data, and in addition, there is generated mask data for allowing any bit to be set to L or H from only the write data.

The bitwise operation unit 315 performs erasure or programming for each bit in a data area corresponding to a write address of the memory cell 316 according to the erasing mask or programming mask generated by the mask generation unit 341. In other words, an operation of erasing to L level is performed only for a bit indicating that erasure is performed when the erasing mask is given, and any rewriting is not performed for the other bits. In addition, an operation of programming to H level is performed only for a bit indicating that programming is performed when the programming mask is given, and any rewriting is not performed for the other bits.

The memory cell 316 includes a variable resistance element. As shown in this figure, the resistance distribution of a variable resistance element is broadly divided into two distributions, called a low resistance state (LRS: Low-Resistance State) and a high resistance state (HRS: High-Resistance State). A variable resistance element functions as a memory cell by associating each of the high resistance state and the low resistance state of the variable resistance element with any one of logical value 0 or 1. The way how a resistance state is associated with any one of logical value 0 or 1 is optionally determined. When the high resistance state is associated with the logical value 0 and the low resistance state is associated with the logical value 1, a cell in the low resistance state is erased to be in the high resistance state and a cell in the high resistance state is programmed to be in the low resistance state. When the low resistance state is associated with the logical value 0 and the high resistance state is associated with the logical value 1, a cell in the high resistance state is erased to be in the low resistance state and a cell in the low resistance state is programmed to be in the high resistance state.

The read processing unit 317 reads data (data 311, ECC 312, and history information 313) from a data area corresponding to a write address of the memory cell 316 prior to the write operation. In this way, the data that is read prior to the write operation is held in the read buffer 330 as pre-read data. Note that the read processing unit 317 is one example of a pre-read processing unit defined in the claims.

The processing in this exemplary functional configuration is repeated appropriately as required by the control unit 350. In the first embodiment, a write operation in an entire erasure mode and a write operation in an entire programming mode as described later are alternately repeated each time when a write operation is performed for each data area. In other words, in the entire erasure mode, the mask generation unit 341 generates an erasing mask from the pre-read data obtained by the read processing unit 317. Then, all bits are set to logical value 0 by allowing the bitwise operation unit 315 to perform erasure in accordance with the erasing mask. Subsequently, the mask generation unit 341 generates a programming mask from the write data, and writing of the write data is completed by allowing the bitwise operation unit 315 to perform programming of a necessary bit in accordance with the programming mask. On the other hand, in the entire programming mode, the mask generation unit 341 generates a programming mask from the pre-read data obtained by the read processing unit 317. Then, all bits are set to logical value 1 by allowing the bitwise operation unit 315 to perform programming in accordance with the programming mask. Subsequently, the mask generation unit 341 generates an erasing mask from the write data, and writing of the write data is completed by allowing the bitwise operation unit 315 to perform erasure of a necessary bit in accordance with the erasing mask. The fact that the previous write operation was performed in any one mode is recorded in the history information 313. Note that, in this example, "L" level corresponds to the logical value 0, and "H" level corresponds to the logical value 1.

### [Specific Example of Write Operation]

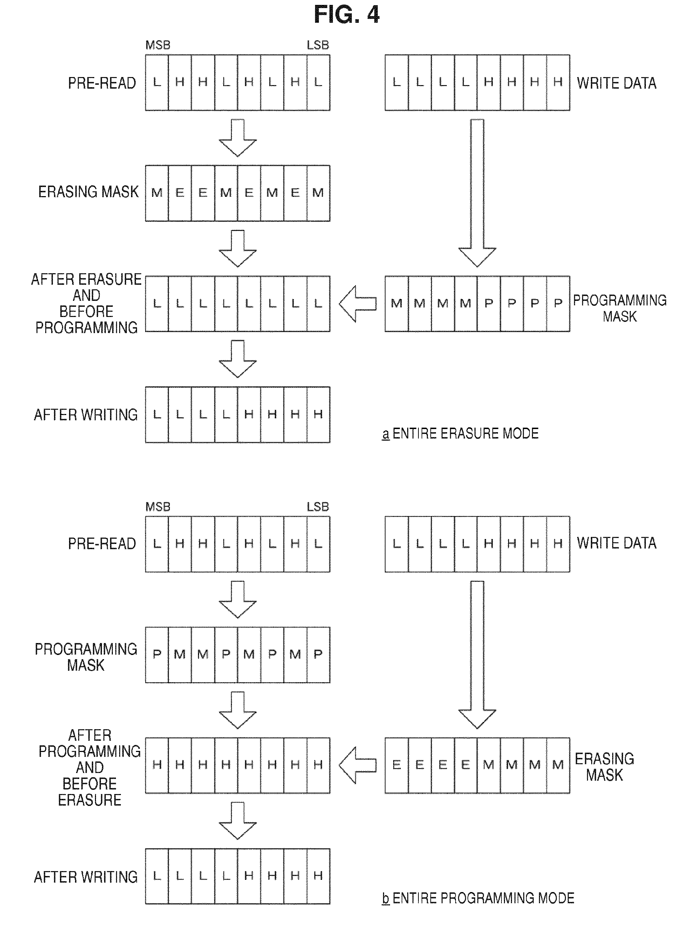

FIG. 4 is a diagram illustrating a specific example of performing writing on a variable resistance element according to the first embodiment of the present technology. In this example, it is assumed that the write data "LLLLHHHH" is to be written in a data area in which "LHHLHLHL" is stored. In the first embodiment, the entire erasure mode and the entire programming mode are repeated in an alternate manner, and at that time, pre-reading is performed, thus erasure or programming is performed only on a necessary bit.

In a of the figure, an operation example when the history information 313 indicates the entire programming mode as the previous mode, that is, an operation example of the entire erasure mode is illustrated. The mask generation unit 341 generates an erasing mask to allow writing for erasing bits that indicate "L" in the pre-read data "LHHLHLHL" to "L" again not to be performed. In other words, an erasing mask "MEEMEMEM" is generated so that a bit to be erased to "L" may be placed only in the bit position having its current value "H". Here, "E" indicates a bit that is to be erased, and "M" indicates a bit that is not to be erased. By using the erasing mask, a data area to be written is entirely set to "L" by the bitwise operation unit 315.

Furthermore, the mask generation unit 341 generates a programming mask to perform writing to bits that indicate "H" in the write data "LLLLHHHH". That is, the programming mask "MMMMPPPP" is generated so that writing is performed only to the bit position in which the write data is "H". Here, "P" indicates a bit that is to be programmed, and "M" indicates a bit that is not to be programmed. By using the programming mask, a data area to be written is entirely set to "LLLLHHHH" by the bitwise operation unit 315.

In b of the figure, an operation example when the history information 313 indicates the entire erasure mode as the previous mode, that is, an operation example of the entire programming mode is illustrated. The mask generation unit 341 generates a programming mask to allow writing for programming bits that indicate "H" in the pre-read data "LHHLHLHL" to "H" again not to be performed. In other words, the programming mask "PMMPMPMP" is generated so that a bit to be programmed to "H" may be placed only in the bit position having its current value "L". By using the programming mask, a data area to be written is entirely set to "H" by the bitwise operation unit 315.

Moreover, the mask generation unit 341 generates an erasing mask to perform writing to bits that indicate "L" in the write data "LLLLHHHH". That is, the programming mask "EEEEMMMM" is generated for the writing to be performed only to the bit position in which the write data is "L". By using the erasing mask, a data area to be written is set to "LLLLHHHH" by the bitwise operation unit 315.

### [Operation of Information Processing System]

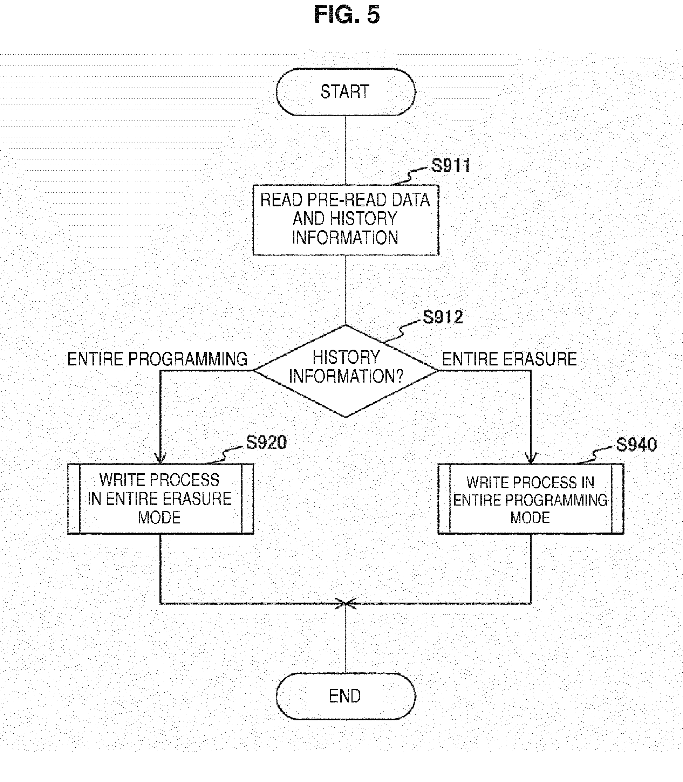

FIG. 5 is a flow diagram illustrating an exemplary procedure of a write process of the information processing system according to the first embodiment of the present technology. First, when write data and a write instruction are issued to the NVRAM 301, the pre-reading of the data 311, the ECC 312, and the history information 313 from the memory cell 316 is performed (step S911). The pre-reading is performed by the read processing unit 317. The write data is held in the write buffer 320, and the pre-read data (data 311, ECC 312, and history information 313) is held in the read buffer 330. Then, if the pre-read history information 313 indicates an entire programming mode as the previous mode (step S912), then the write process is performed in the entire erasure mode (step S920). On the other hand, if the pre-read history information 313 indicates an entire erasure mode as the previous mode, then the write process is performed in the entire programming mode (step S940).

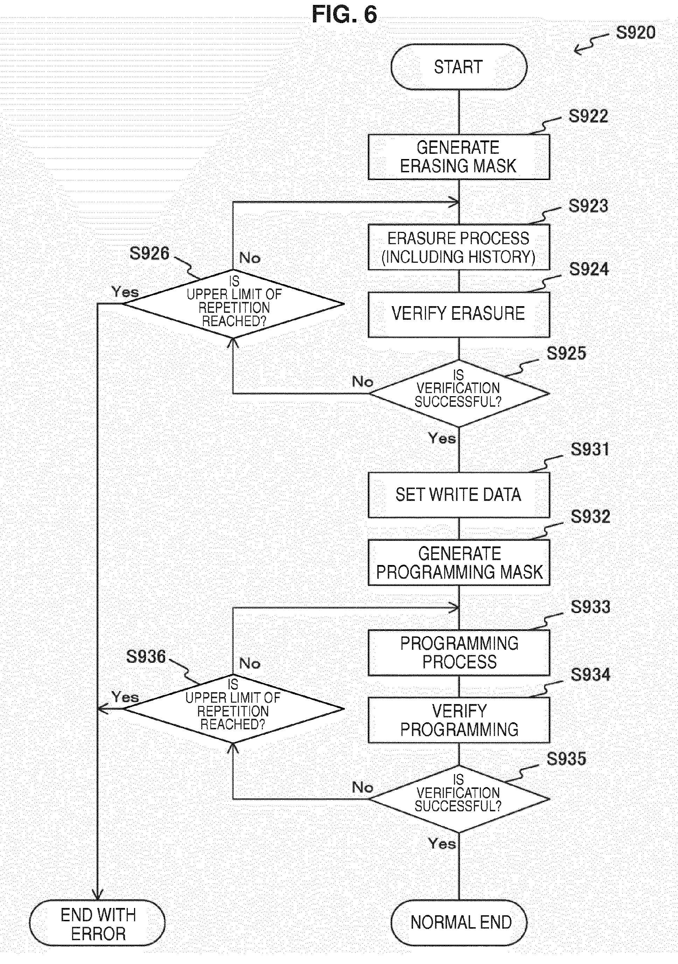

FIG. 6 is a flow diagram illustrating an exemplary procedure of the write process in the entire erasure mode (step S920) according to the first embodiment of the present technology. First, the mask generation unit 341 generates an erasing mask to allow writing for erasing a bit that indicates "L" in the pre-read data to "L" again not to be performed (step S922). Then, a process of erasing the data 311, the ECC 312, and the history information 313 is performed in accordance with the erasing mask (step S923). At this time, in the first embodiment, the history information 313 is also erased to "L". Note that, if the history information 313 is "L", it indicates that the write process was performed in the entire erasure mode at the previous time. Verification (Verify) is performed at the time of erasing (step S924), and it is repeated until the verification is successful (step S925: No). However, if an upper limit number of repetition times is reached (step S926: Yes), then the process is ended with error.

Next, the write data is set to the write buffer 320 (step S931). Then, the mask generation unit 341 generates a programming mask to perform writing to a bit that indicates "H" in the write data (step S932). Then, a process of programming the data 311 is performed in accordance with the programming mask (step S933). Verification (Verify) is performed at the time of programming (step S934), and it is repeated until the verification is successful (step S935: No). However, if an upper limit number of repetition times is reached (step S936: Yes), then the process is ended with error.

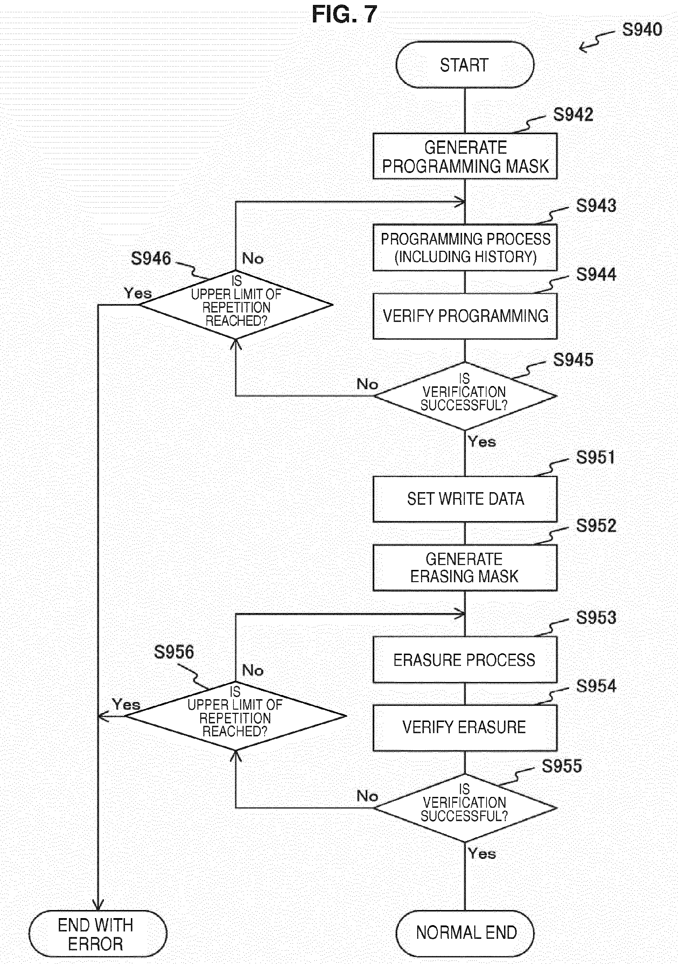

FIG. 7 is a flow diagram illustrating an exemplary procedure of the write process in the entire programming mode (step S940) according to the first embodiment of the present technology. First, the mask generation unit 341 generates a programming mask to allow writing for erasing a bit that indicates "H" in the pre-read data to "H" again not to be performed (step S942). Then, a process of programming the data 311, the ECC 312, and the history information 313 is performed in accordance with the programming mask (step S943). At this time, in the first embodiment, the history information 313 is also erased to "H". Note that, if the history information 313 is "H", it indicates that the write process was performed in the entire programming mode at the previous time. Verification (Verify) is performed at the time of programming (step S944), and it is repeated until the verification is successful (step S945: No). However, if an upper limit number of repetition times is reached (step S946: Yes), then the process is ended with error.

Next, the write data is set to the write buffer 320 (step S951). Then, the mask generation unit 341 generates an erasing mask to perform writing for erasing a bit that indicates "L" in the write data (step S952). Then, a process of erasing the data 311 is performed in accordance with the erasing mask (step S953). Verification (Verify) is performed at the time of erasing (step S954), and it is repeated until the verification is successful (step S955: No). However, if an upper limit number of repetition times is reached (step S956: Yes), then the process is ended with error.

In this way, in accordance with the first embodiment of the present technology, the entire erasure state and the entire programming state occur in an alternate manner each time when the write process is performed for each data area, thus it is possible to eliminate variations in data retention characteristics of non-volatile memory. In particular, in the first embodiment, erasing or programming only a necessary bit can be performed depending on the result obtained by pre-reading, thus it is possible to avoid over-erasing or over-writing. At this time, the write data is not referenced, and thus an entire erasure or programming state can be made by looking ahead before the write data is determined. In addition, the history information is read at the same time as the data is read and the history information is updated at the same time as the data is updated, thus it is possible to simplify the processing procedure for history information. Additionally, the write process based on the history information is performed within the NVRAM 301 in a closed manner, thus there is no need to be aware of it from the external.

### <2. Second Embodiment>

### [Configuration of Information Processing System]

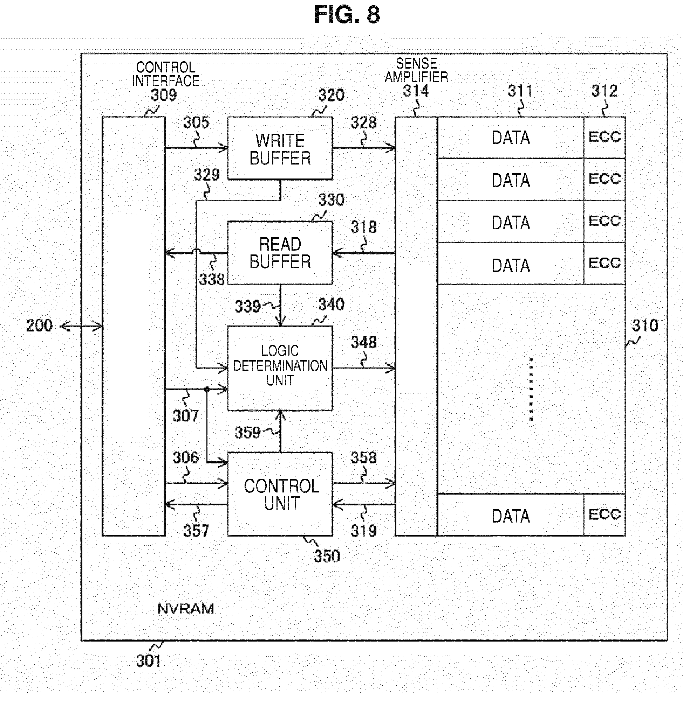

FIG. 8 is a diagram illustrating an exemplary configuration of the NVRAM 301 according to a second embodiment of the present technology. It is assumed that the configuration of the information processing system according to the second embodiment is similar to that of the first embodiment. In the first embodiment described above, the history information is stored in the memory array 310 as the history information 313, but, in the second embodiment, the history information is managed by the internal memory 220, the volatile memory 303, or the like. Thus, the history information is supplied to the control unit 350 and the logic determination unit 340 through the control interface 309 from the external of the NVRAM 301. Except for those, the configuration of the NVRAM 301 is similar to that of the first embodiment. In addition, its functional configuration is also similar to that of the first embodiment, but the repetitive control of the entire erasure mode and the entire programming mode is implemented in the control interface 309. However, the mask data for setting all bits to L or H once is not generated, and they are erased or programmed in a batch as described later.

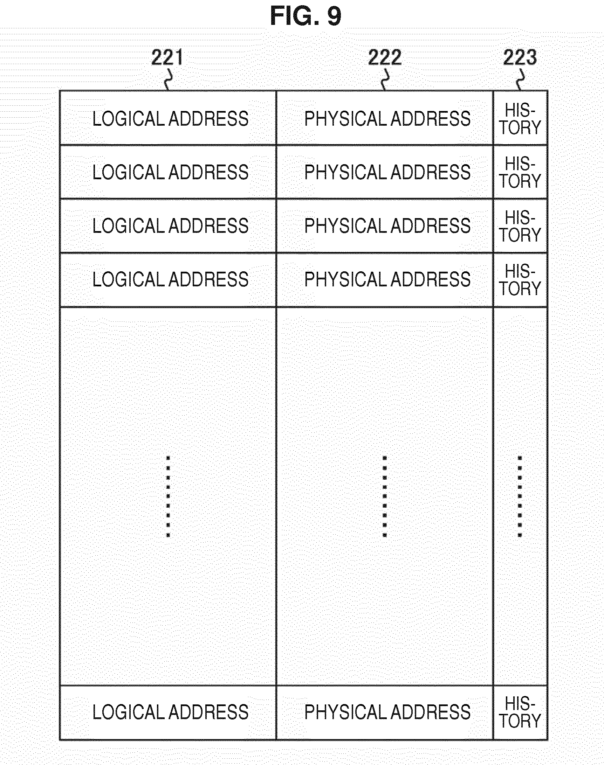

FIG. 9 is a diagram illustrating an exemplary configuration of a history information table according to the second embodiment of the present technology. In this example, it is assumed that the history information is stored in the history information table of the internal memory 220. When the internal memory 220 is non-volatile memory, the history information may be saved in non-volatile memory such as the flash memory 302 at predetermined intervals to prevent information from being lost due to a loss of power. The history information table stores a logical address 221, a physical address 222, and history information 223, which are associated with each data area.

The logical address 221 is a logical address assigned to a data area in the host computer 100. The physical address 222 is an address for specifying a storage area of the NVRAM 301 which corresponds to the logical address 221. When a logical address is specified from the host computer 100, the address conversion from the logical address into a physical address is performed by allowing the logical address 221 to be paired with the physical address 222.

The history information 223 is information about the history of a write process on an area corresponding to the logical address 221 and the physical address 222, and indicates that any one of the modes was used in the previous write operation. When there are two types of modes of write operation, the history information 223 is sufficient to have only one bit, but it may be possible to determine a mode, for example by the majority decision, using a plurality of bits to improve reliability.

### [Specific Example of Write Operation]

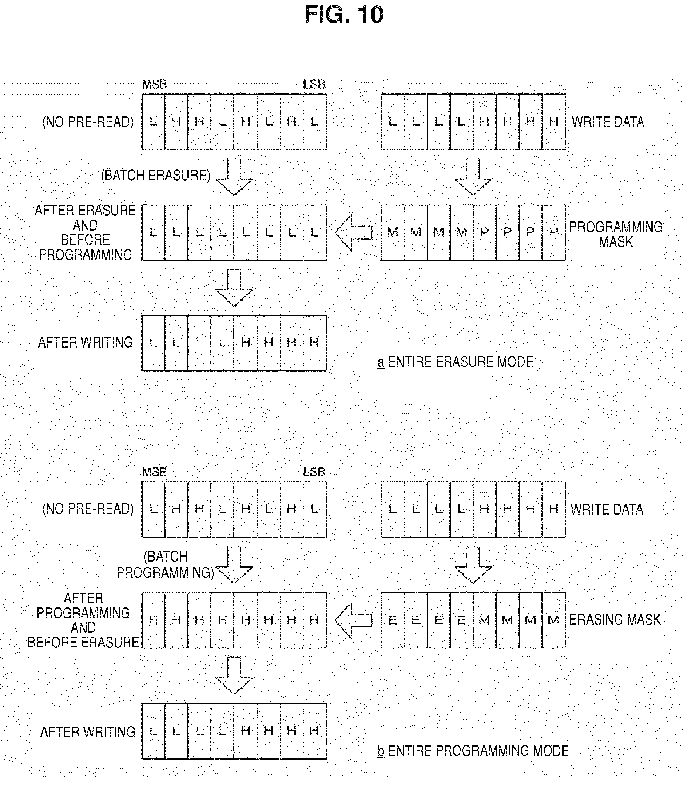

FIG. 10 is a diagram illustrating a specific example of performing writing to a variable resistance element according to the second embodiment of the present technology. In this example, it is assumed that the write data "LLLLHHHH" is written in the data area in which "LHHLHLHL" is stored. In the second embodiment, the entire erasure mode and the entire programming mode are alternately repeated, and, at that time, pre-reading is not performed, and writing for erasure and programming to all bits of the data area to be written is performed.

In a of the figure, an operation example when the history information 223 indicates the entire programming mode as the previous mode, that is, an operation example of the entire erasure mode is illustrated. The data areas to be written are erased in a batch without being pre-read. In other words, the data area to be written is entirely erased to "L" by the bitwise operation unit 315.

Furthermore, the mask generation unit 341 generates a programming mask to perform writing to bits that indicate "H" in the write data "LLLLHHHH". In other words, the programming mask "MMMMPPPP" is generated by the mask generation unit 341 so that writing is performed only to the bit position in which the write data is "H". Here, "P" indicates a bit which is to be programmed, and "M" indicates a bit which is not to be programmed. By using the programming mask, the data area to be written becomes "LLLLHHHH" by the bitwise operation unit 315.

In b of the figure, an operation example when the history information 223 indicates the entire erasure mode as the previous mode, that is, an operation example of the entire programming mode is illustrated. The data areas to be written are programmed in a batch without being pre-read. In other words, the data area to be written is entirely programmed to "H" by the bitwise operation unit 315.

Moreover, the mask generation unit 341 generates an erasing mask to perform writing to bits that indicate "L" in the write data "LLLLHHHH". In other words, the programming mask "EEEEMMMM" is generated so that writing is performed only to the bit position in which the write data is "L". By using the erasing mask, the data area to be written becomes "LLLLHHHH" by the bitwise operation unit 315.

### [Operation of Information Processing System]

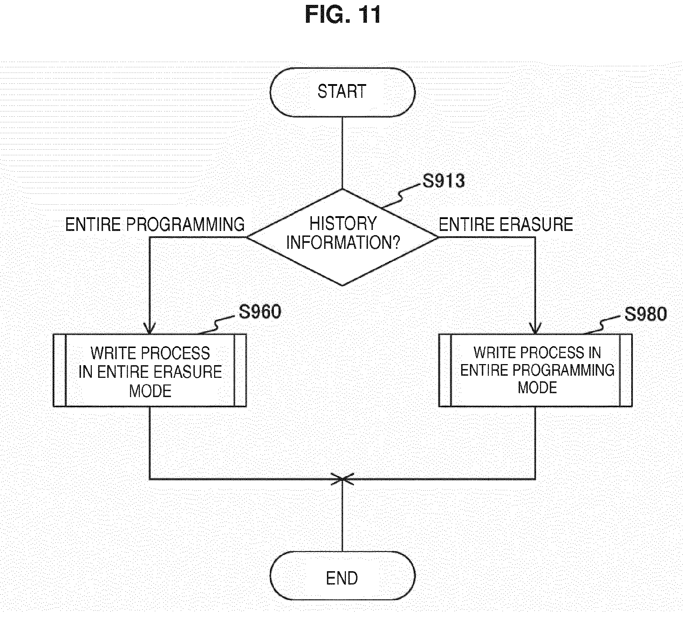

FIG. 11 is a flow diagram illustrating an exemplary procedure of a write process of the information processing system according to the second embodiment of the present technology. First, if write data and a write instruction are issued to the NVRAM 301, then the history information 223 of the history information table is determined, and if the history information 223 indicates the entire programming mode as the previous mode (step S913), then a write process is performed in the entire erasure mode (step S960). On the other hand, if the history information 223 indicates the entire erasure mode as the previous mode, then a write process is performed in the entire programming mode (step S980).

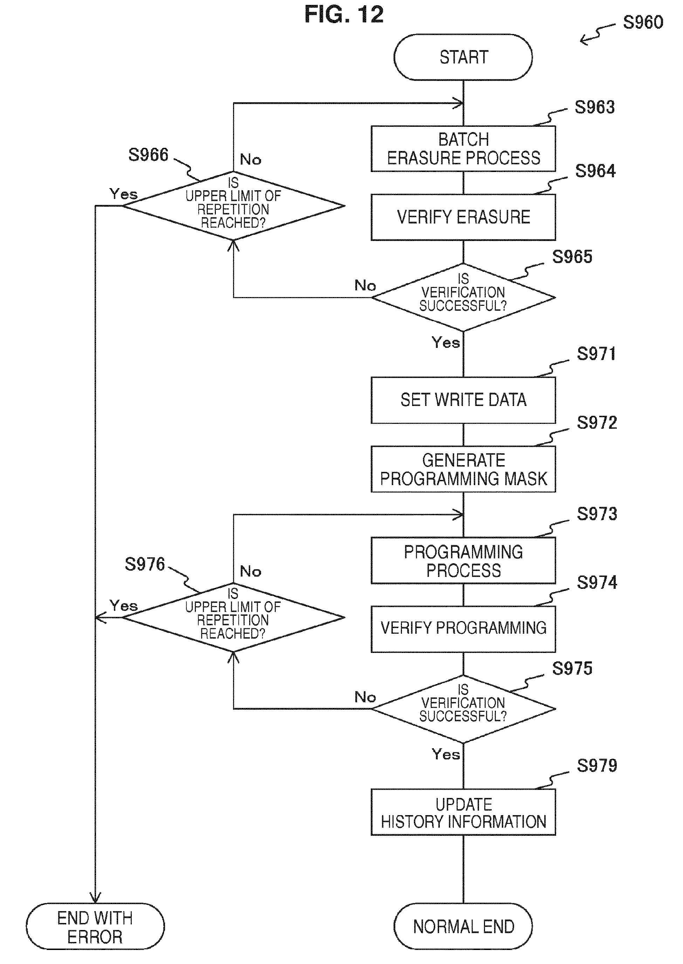

FIG. 12 is a flow diagram illustrating an exemplary procedure of the write process in the entire erasure mode (step S960) according to the second embodiment of the present technology. The basic processing procedure is similar to that of the first embodiment in FIG. 6, but in the second embodiment, pre-reading is not performed, thus an erasing mask for the entire erasure is not generated. Alternatively, the batch erasure of the data area to be written is performed (step S963). In addition, in the second embodiment, the history information is not managed by the memory array 310, thus the erasure of the history information is not performed at this time, and the history information 223 of the history information table is updated to "L" as a final process (step S979). Note that, if the history information 223 is "L", then it indicates that the write process was performed in the entire erasure mode at the previous time.

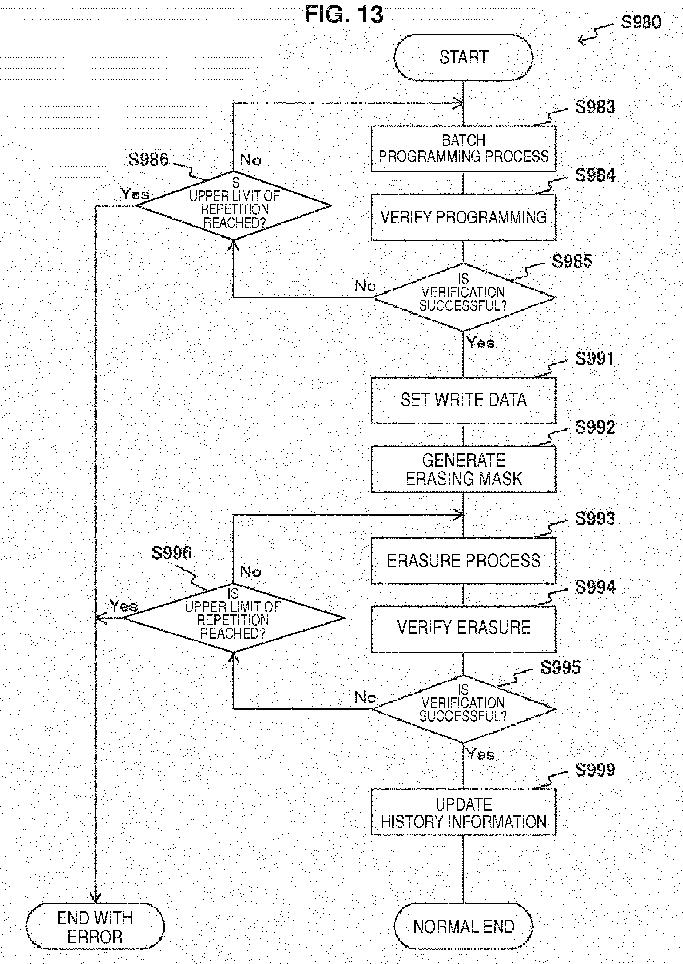

FIG. 13 is a flow diagram illustrating an exemplary procedure of the write process in the entire programming mode (step S980) according to the second embodiment of the present technology. The basic processing procedure is similar to that of the first embodiment in FIG. 7, but in the second embodiment, pre-reading is not performed, thus a programming mask for the entire programming is not generated. Alternatively, the batch programming of the data area to be written is performed (step S983). In addition, in the second embodiment, the history information is not managed by the memory array 310, thus the programming of the history information is not performed at this time, and the history information 223 of the history information table is programmed to "H" as a final process (step S999). Note that, if the history information 223 is "H", then it indicates that the write process was performed in the entire programming mode at the previous time.

In this way, according to the second embodiment of the present technology, the entire erasure state and the entire programming state occur in an alternate manner each time when the write process is performed for each data area, thus it is possible to eliminate variations in data retention characteristics of non-volatile memory. In particular, in the second embodiment, pre-reading is not performed prior to the write operation, thus it is possible to perform the write process at a high speed. In this case, there is a possibility of causing an over-erasure or over-programming depending on the state of the data area to be written, but the writing of the same polarity is limited to up to a maximum of twice. In other words, the over-erasure or over-programming for a variable resistance element can be allowed up to a maximum of one time, respectively, and it will be especially suitable write process method if high-speed performance is regarded as more important than other things.

### [Modified Example]

In the second embodiment, the processing procedure in which pre-reading is not performed prior to the write operation is employed on the assumption of the configuration in which the history information is stored in the history information table external to the NVRAM 301. On the other hand, while assuming that the configuration of storing the history information in the history information table external to the NVRAM 301 is used, the erasure or programming may be performed by generating an erasing mask or programming mask based on the result obtained by pre-reading in a similar manner to the first embodiment. In this case, it is possible to avoid over-erasing or over-writing, as is the case with the first embodiment.

### <3. Third Embodiment>

In the second embodiment described above, the processing procedure in which pre-reading is not performed prior to the write operation is employed on the assumption of the configuration in which the history information is stored in the history information table external to the NVRAM 301. Meanwhile, the modified example thereof illustrates that pre-reading can be performed with the same configuration. In the third embodiment, on the assumption that it has a similar configuration to that of the second embodiment, there is employed a processing procedure in which programming is performed by generating a programming mask based on the result obtained by pre-reading when a batch programming is performed and a batch erasure is performed when an entire erasure is performed.

### [Specific Example of Write Operation]

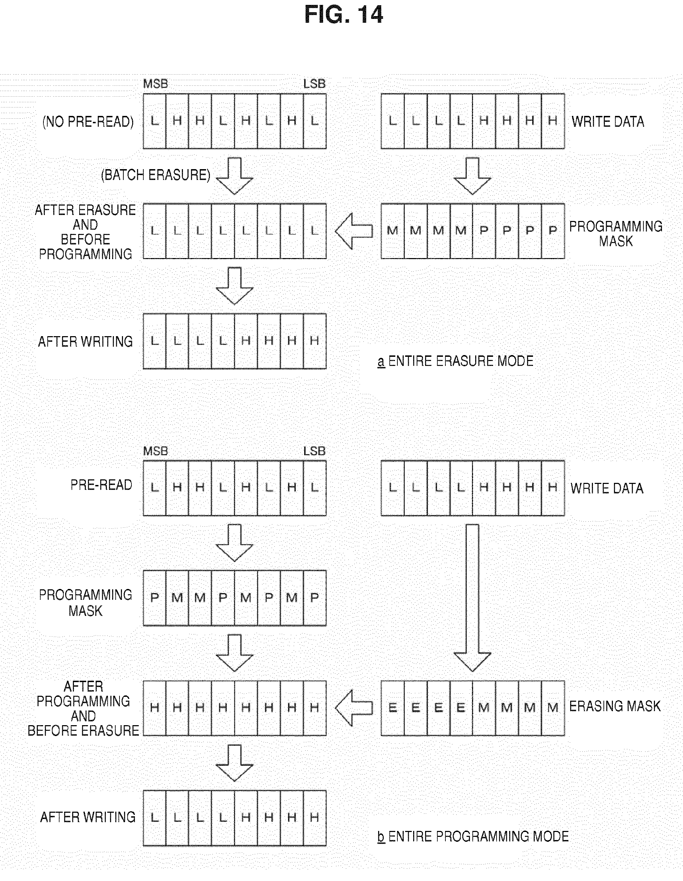

FIG. 14 is a diagram illustrating a specific example of performing writing on a variable resistance element according to the third embodiment of the present technology. In this example, it is assumed that the write data "LLLLHHHH" is written in the data area in which "LHHLHLHL" is stored. In the third embodiment, the entire erasure mode and the entire programming mode are alternatively repeated, thus, at the time of the entire erasure mode, pre-reading is performed and then erasure is performed only on a necessary bit, but at the time of the entire programming mode, pre-reading is not performed and a batch programming is performed.

In a of the figure, an operation example when the history information 223 indicates the entire programming mode as the previous mode, that is, an operation example of the entire erasure mode is illustrated. The data area to be written is erased in a batch without being pre-read. In other words, the data area to be written is entirely erased to "H" by the bitwise operation unit 315.

Furthermore, the mask generation unit 341 generates a programming mask to perform writing to bits that indicate "H" in the write data "LLLLHHHH". That is, the programming mask "MMMMPPPP" is generated so that writing is performed only to the bit position in which the write data is "H". Here, "P" indicates a bit that is to be programmed, and "M" indicates a bit that is not to be programmed. By using this programming mask, the data area to be written is set to "LLLLHHHH" by the bitwise operation unit 315.

In b of the figure, an operation example when the history information 223 indicates the entire erasure mode as the previous mode, that is, an operation example of the entire programming mode is illustrated. The mask generation unit 341 generates a programming mask to allow writing for programming bits that indicate "H" in the pre-read data "LHHLHLHL" to "H" again not to be performed. In other words, the programming mask "PMMPMPMP" is generated so that a bit to be programmed to "H" may be placed only in the bit position having its current value "L". By using this programming mask, the data area to be written is entirely set to "H" by the bitwise operation unit 315.

Moreover, the mask generation unit 341 generates an erasing mask to perform writing to bits indicate "L" in the write data "LLLLHHHH". That is, the programming mask "EEEEMMMM" is generated so that writing is performed only to the bit position in which the write data is "L". By using this erasing mask, the data area to be written is set to "LLLLHHHH" by the bitwise operation unit 315.

### [Operation of Information Processing System]

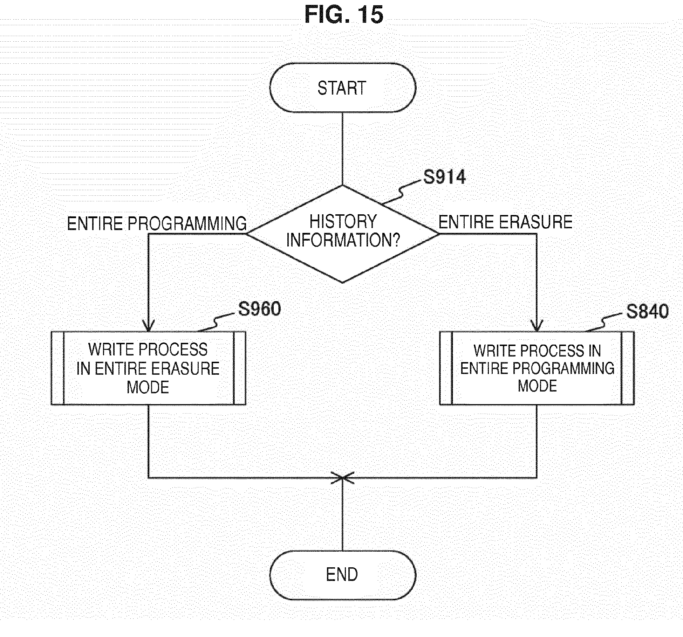

FIG. 15 is a flow diagram illustrating an exemplary procedure of a write process of the information processing system according to the third embodiment of the present technology. First, if write data and a write instruction are issued to the NVRAM 301, then the history information 223 of the history information table is determined, and if the history information 223 indicates an entire programming mode as the previous mode (step S914), then a write process is performed in the entire erasure mode (step S960). The write process in the entire erasure mode is similar to the processing procedure of the second embodiment described in FIG. 12. On the other hand, if the history information 223 indicates an entire erasure mode as the previous mode, then a write process is performed in the entire programming mode (step S840). The write process in the entire programming mode is similar to the processing procedure of the first embodiment in which pre-reading is performed, but it is different from the first embodiment in that the configuration of storing the history information in the history information table external to the NVRAM 301 is employed, as described later.

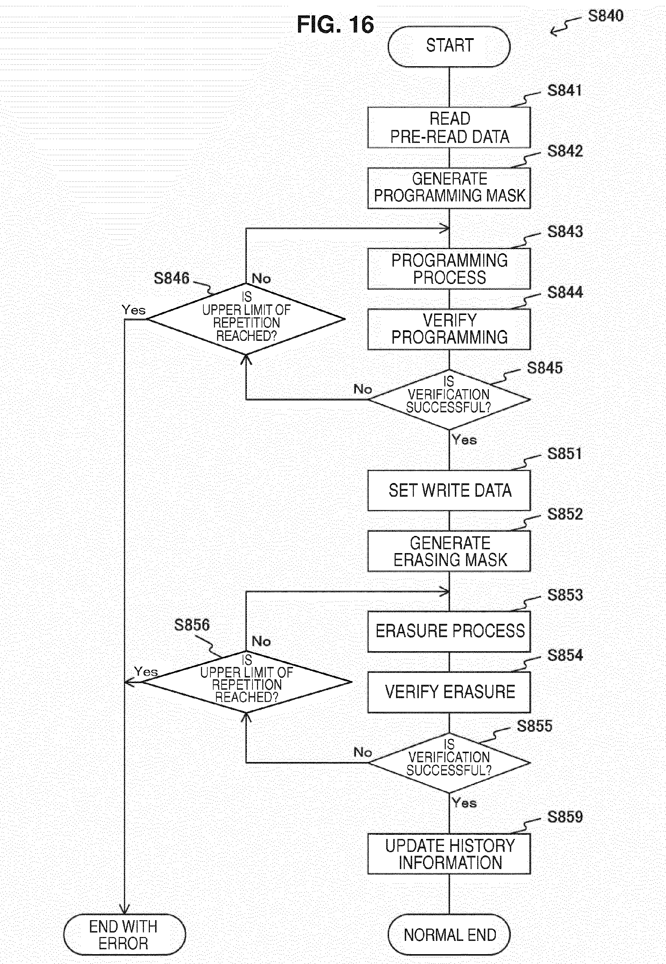

FIG. 16 is a flow diagram illustrating an exemplary procedure of the write process in the entire programming mode (step S840) according to the third embodiment of the present technology. First, the read processing unit 317 pre-reads the data 311 and the ECC 312 from the memory cell 316 (step S841). Then, the mask generation unit 341 generates a programming mask so that writing for erasing a bit that indicates "H" in the pre-read data to "H" again is not to be performed (step S842). Then, a process of programming the data 311 and the ECC 312 is performed in accordance with the generated programming mask (step S843). Verification (Verify) is performed at the time of programming (step S844), and it is repeated until the verification is successful (step S845: No). However, if an upper limit number of repetition times is reached (step S846: Yes), then the process is ended with error.

Next, the write data is set to the write buffer 320 (step S851). Then, the mask generation unit 341 generates an erasing mask to perform writing for erasing a bit that indicates "L" in the write data (step S852). Then, a process of erasing the data 311 and the ECC 312 is performed in accordance with the erasing mask (step S953). Verification (Verify) is performed at the time of erasing (step S854), and it is repeated until the verification is successful (step S855: No). However, if an upper limit number of repetition times is reached (step S856: Yes), then the process is ended with error.

In the third embodiment, the history information is not managed by the memory array 310, thus programming of the history information is not performed in step S843, and the history information 223 of the history information table is programmed to "H" as a final process (step S859). Note that, if the history information 223 is "H", then it indicates that the write process was performed in the entire programming mode at the previous time.

In this way, according to the third embodiment of the present technology, the entire erasure state and the entire programming state occur in an alternate manner each time when the write process is performed for each data area, thus it is possible to eliminate variations in data retention characteristics of non-volatile memory. In particular, in the third embodiment, the pre-reading is performed only when the entire programming is performed, thus performing the write process at a high speed and preventing the entire programming from being performed excessively can be obtained in a good balance.

It should be noted the above-described embodiments are examples to realize the present technology, and items in the embodiments are in a corresponding relationship with invention specific items in the claims. At the same time, the invention specific items in the claims are in a corresponding relationship with items of the embodiments of the present technology to which the same names as those of the invention specific items are given. However, the present technology is not limited to the embodiments, and can be realized by variously modifying the embodiments within the scope of the technology. For example, depending on to what extent the over-erasing or over-programming of the memory cell is acceptable, one mode is continuously used a plurality of times and then it may be switched to the other mode by using history of one or more bits.

In addition, the procedures of the processes described in the embodiments above may be understood as a method that includes a series of the processes, or as a program that instructs a computer to execute the series of the processes and a recording medium in which such a program is stored. As the recording medium, for example, CDs (Compact Discs), MDs (MiniDiscs), DVD (Digital Versatile Disks), memory cards, blu-ray discs (Blu-ray Discs (registered trademark)), and the like can be used.

Additionally, the present technology may also be configured as below.
(1) A storage control device including:
   a history information holding unit configured to hold history information in a predetermined data area of a memory cell holding either a first value or a second value for each bit, the history information indicating which mode of a first mode or a second mode is employed upon a previous write operation, the first mode setting all bits to the first value and then setting any bit to the second value, the second mode setting all bits to the second value and then setting any bit to the first value; and
      a bitwise operation unit configured to perform a write operation in the second mode if the history information indicates the first mode and to perform a write operation in the first mode if the history information indicates the second mode.
(2) The storage control device according to (1), further including:
   a pre-read processing unit configured to read pre-read data from a data area to be written prior to a write operation,
   wherein the bitwise operation unit rewrites only a bit in which the pre-read data indicates the second value to the first value to set all bits to the first value when the write operation in the first mode is performed, and rewrites only a bit in which the pre-read data indicates the first value to the second value to set all bits to the second value when the write operation in the second mode is performed.
(3) The storage control device according to (1), wherein the bitwise operation unit rewrites all bits in a data area to be written to the first value to set all bits to the first value when the write operation in the first mode is performed, and rewrites all bits in a data area to be written to the second value to set all bits to the second value when the write operation in the second mode is performed.
(4) The storage control device according to (1), further including:
   a pre-read processing unit configured to read pre-read data from a data area to be written prior to a write operation,
   wherein the bitwise operation unit rewrites all bits in a data area to be written to the first value to set all bits to the first value when the write operation in the first mode is performed, and rewrites only a bit in which the pre-read data indicates the first value to the second value to set all bits to the second value when the write operation in the second mode is performed.
(5) A storage device including:
   a memory cell configured to hold either a first value or a second value for each bit;
   a history information holding unit configured to hold history information in a predetermined data area of the memory cell, the history information indicating which mode of a first mode or a second mode is employed upon a previous write operation, the first mode setting all bits to the first value and then setting any bit to the second value, the second mode setting all bits to the second value and then setting any bit to the first value; and
   a bitwise operation unit configured to perform a write operation in the second mode if the history information indicates the first mode and to perform a write operation in the first mode if the history information indicates the second mode.
(6) The storage device according to (5), wherein the memory cell is a variable resistance element.
(7) An information processing system including:
   a memory cell configured to hold either a first value or a second value for each bit;
   a history information holding unit configured to hold history information in a predetermined data area of the memory cell, the history information indicating which mode of a first mode or a second mode is employed upon a previous write operation, the first mode setting all bits to the first value and then setting any bit to the second value, the second mode setting all bits to the second value and then setting any bit to the first value;
   a bitwise operation unit configured to perform a write operation in the second mode if the history information indicates the first mode and to perform a write operation in the first mode if the history information indicates the second mode; and
   a host computer configured to issue a read command or a write command to the memory array.
(8) A storage controlling method including:
   performing a history information obtaining process of obtaining history information for a predetermined data area of a memory cell holding either a first value or a second value for each bit, the history information indicating which mode of a first mode or a second mode is employed upon a previous write operation, the first mode setting all bits to the first value and then setting any bit to the second value, the second mode setting all bits to the second value and then setting any bit to the first value; and
   performing a bitwise operation process of performing a write operation in the second mode if the history information indicates the first mode and performing a write operation in the first mode if the history information indicates the second mode.

### Reference Signs List

- 100: host computer
- 200: memory controller
- 201: host interface
- 210: processor
- 220: internal memory
- 230: ECC processing unit
- 250: peripheral circuit
- 280: bus
- 291-293: memory interface
- 300: memory
- 301: non-volatile random access memory (NVRAM)
- 302: flash memory
- 303: volatile memory
- 309: control interface
- 310: memory array
- 314: sense amplifier
- 315: bitwise operation unit
- 316: memory cell
- 317: read processing unit
- 320: write buffer
- 330: read buffer
- 340: logic determination unit
- 341: mask generation unit
- 350: control unit
- 400: memory system

## Claims

1. A storage control device comprising:
a history information holding unit configured to hold history information in a predetermined data area of a memory cell holding either a first value or a second value for each bit, the history information indicating which mode of a first mode or a second mode is employed upon a previous write operation, the first mode setting all bits to the first value and then setting any bit to the second value, the second mode setting all bits to the second value and then setting any bit to the first value; and
a bitwise operation unit configured to perform a write operation in the second mode if the history information indicates the first mode and to perform a write operation in the first mode if the history information indicates the second mode.

2. The storage control device according to claim 1, further comprising:
a pre-read processing unit configured to read pre-read data from a data area to be written prior to a write operation,
wherein the bitwise operation unit rewrites only a bit in which the pre-read data indicates the second value to the first value to set all bits to the first value when the write operation in the first mode is performed, and rewrites only a bit in which the pre-read data indicates the first value to the second value to set all bits to the second value when the write operation in the second mode is performed.

3. The storage control device according to claim 1, wherein the bitwise operation unit rewrites all bits in a data area to be written to the first value to set all bits to the first value when the write operation in the first mode is performed, and rewrites all bits in a data area to be written to the second value to set all bits to the second value when the write operation in the second mode is performed.

4. The storage control device according to claim 1, further comprising:
a pre-read processing unit configured to read pre-read data from a data area to be written prior to a write operation,
wherein the bitwise operation unit rewrites all bits in a data area to be written to the first value to set all bits to the first value when the write operation in the first mode is performed, and rewrites only a bit in which the pre-read data indicates the first value to the second value to set all bits to the second value when the write operation in the second mode is performed.

5. A storage device comprising:
a memory cell configured to hold either a first value or a second value for each bit;
a history information holding unit configured to hold history information in a predetermined data area of the memory cell, the history information indicating which mode of a first mode or a second mode is employed upon a previous write operation, the first mode setting all bits to the first value and then setting any bit to the second value, the second mode setting all bits to the second value and then setting any bit to the first value; and
a bitwise operation unit configured to perform a write operation in the second mode if the history information indicates the first mode and to perform a write operation in the first mode if the history information indicates the second mode.

6. The storage device according to claim 5, wherein the memory cell is a variable resistance element.

7. An information processing system comprising:
a memory cell configured to hold either a first value or a second value for each bit;
a history information holding unit configured to hold history information in a predetermined data area of the memory cell, the history information indicating which mode of a first mode or a second mode is employed upon a previous write operation, the first mode setting all bits to the first value and then setting any bit to the second value, the second mode setting all bits to the second value and then setting any bit to the first value;
a bitwise operation unit configured to perform a write operation in the second mode if the history information indicates the first mode and to perform a write operation in the first mode if the history information indicates the second mode; and
a host computer configured to issue a read command or a write command to the memory array.

8. A storage controlling method comprising:
performing a history information obtaining process of obtaining history information for a predetermined data area of a memory cell holding either a first value or a second value for each bit, the history information indicating which mode of a first mode or a second mode is employed upon a previous write operation, the first mode setting all bits to the first value and then setting any bit to the second value, the second mode setting all bits to the second value and then setting any bit to the first value; and
performing a bitwise operation process of performing a write operation in the second mode if the history information indicates the first mode and performing a write operation in the first mode if the history information indicates the second mode.
